# EUROPEAN PATENT SPECIFICATION

(11) **EP 2 413 372 B1**
(45) Date of publication and mention of the grant of the patent: **01.11.2017**
(21) Application number: 11171502.5
(22) Date of filing: 27.06.2011
(51) Int. Cl.: H01L 31/0304, H01L 31/18, H01L 31/0735, H01L 21/304

(54) **Method for fabricating concentrated solar cell chip without edge current leakage**
Verfahren zur Herstellung eines konzentrierten Solarzellenchips ohne Kantenleckstrom
Procédé de fabrication d'une puce de cellule solaire concentré sans fuite de courant de bord

(30) Priority: 29.07.2010 CN 201010244598
(43) Date of publication of application: 01.02.2012
(73) Proprietor: Xiamen Sanan Optoelectronics Technology Co., Ltd., Xiamen City 361009 (CN)
(72) Inventor: Wu, Zhimin, Siming District, Xiamen City Fujian 361009 (CN); Leung, Charles Siuhuen, Siming District, Xiamen City Fujian 361009 (CN); Lin, Guijiang, Siming District, Xiamen City Fujian 361009 (CN); Xiong, Weiping, Siming District, Xiamen City Fujian 361009 (CN); Xu, Wencui, Siming District, Xiamen City Fujian 361009 (CN)
(74) Representative: Witte, Weller & Partner Patentanwälte mbB

(56) References cited:
- EP-A1- 1 916 718
- JP-A- 2004 022 656
- JP-A- 2006 041 263
- JP-A- 2009 146 923
- US-A- 4 836 861
- US-A- 5 882 986
- US-A1- 2006 068 567
- US-A1- 2009 189 257

## Description

### FIELD OF THE INVENTION

The present invention relates to a method for fabricating a solar cell chip, and particularly to a method for fabricating a concentrated solar cell chip without edge current leakage.

### BACKGROUND OF THE INVENTION

Presently, concentrated solar power systems normally use a gallium arsenide (GaAs)-based multi-junction solar cell. Its concentration factor can be as large as 500, or even in the scale of thousands, due to the advancement of material performance and processing technology. Moreover, its chip size is much smaller than traditional silicon-based cells, greatly reducing the semiconductor material consumption, and making it the most promising solar cell technology. However, as the size of the chip shrinks, the ratio of the perimeter to the area of the chip increases significantly, so that edge current leakage has much larger impact on the performance of the cell. In contrast, in traditional planar solar cells, impact of edge current on the performance of the cell is minimal because the ratio of surface area of the edge to the overall emitting area of the chip is small. Therefore, in order to improve the performance of concentrated multi-junction solar cells, especially for those cells that are operating under high concentration factor, edge current leakage should be eliminated in the chip for high conversion efficiency.

The edge current leakage is originated from the formation of a new energy level in the forbidden band of the semiconductor band structure due to a difference between the bulk and surface characteristic in the crystal structures of the semiconductor material. Such phenomenon is known as the surface state, and the newly formed energy level becomes a center of carrier recombination. Possible causes of the surface recombination center include: damaged lattice periodicity of the semiconductor's surface; deformed crystal structure due to a difference between the forces on the surface atoms and the inside atoms; contaminated surface; and damages from fabrication, especially the severe damages to the sidewalls of the dicing street by the dicing blade during dicing, resulting in dangling bonds which combine with impurities from the environment. For example, instable arsenic and gallium oxides are formed on the surface of GaAs when exposed to air. The arsenic oxides then react with bulk gallium atoms, extending the oxidation of bulk semiconductor material. Consequently, both the arsenic oxides and gallium oxides introduce an excessive density of surface states. Under high-current operation of the solar cell chip, the abovementioned factors worsen the edge current leakage. Therefore, it is desirable to provide a method which reduces the damages as well as providing a sloped profile to the chip by the dicing blade, repairs the semiconductor's surface, removes the oxides on the surface of GaAs, and Finally deposits a passivation layer to protect the surface and reduce surface-state density. Generally, in semiconductor and photoelectric devices, the dicing street has a rough surface, making it circuit to deposit high quality passivation film. Moreover, the passivation film is easily damaged, or even peeling off during dicing operation.

EP 1 196 718 A1 discloses a method for fabricating a solar chip suitable for being coupled to a concentrator and relating to the reduction of leakage current on cell edge sides. The method comprises the following steps, namely forming a groove along a dicing street of a cell chip by a precise slope-sidewall cutting method using a cutting blade, such that the sidewalls of the formed groove are sloped, followed by performing chemical polishing on the sidewalls of the sloped sidewall groove, and cutting through the cell chip to separate the solar cell chip into individual dices, wherein the cutting width is smaller than the width of the slope-sidewall groove.

US 4 836 861 A discloses a method which includes the steps of forming an insulating layer after an etching step, which serve as an anti-reflection and as a passivation layer, over a surface of the cell chip, to prevent current leakage.

US 2006/0068567 A1 discloses to perform both, classical blade and laser dicing after completion of the full wafer including passivation stack.

To solve the problem above, the present invention teaches a method for fabricating a solar cell chip without edge current leakage in a concentrated solar power system comprising the steps of forming a groove along a dicing street of the cell chip by a precise slope-sidewall cutting method using a cutting blade having sloping sides, such that sidewalls of performed groove are sloped; performing chemical polishing on the sidewalls of the sloped sidewall groove; forming insulating materials which serves as an anti-reflection and a passivation layer, over a surface of the cell chip and over a surface on the sloped sidewalls of the groove, to prevent current leakage; after forming the insulation materials, cutting through the cell chip by using a conventional blade to separate the solar cell chip into individual dices, wherein the width of the conventional blade is smaller than the width of the slope-sidewall groove cutting blade.

In the process according to the present invention, the shape of the blade used in the above precise cutting method has sloping sides having a sloping angle which ranges between 10°∼80°. First, a groove is formed with sloped sidewalls along the intended dicing street. The blade is specially shaped such that when a groove is formed on the dicing street, the sidewall of the cut groove has a sloping angle. Secondly, a different dicing blade having a width that is smaller than the precise sloping dicing blade is used to cut through and separate the solar cell chips. Hence, the sidewalls of the groove will not come into contact with the blade during the subsequent step of cutting through the chip, thereby avoiding damages to the sloped profile on the edge of the chip. In addition, the sloping sidewalls allow improved coverage when forming a dense passivation layer onto the surface, resulting in a high quality passivation layer to reduce leakage current.

The step of performing chemical polishing on the sidewalls of the sloped groove along the dicing street includes the use of a wet etching method and/or a dry etching method to reduce sidewall damages from the dicing operation. In the wet etching method, a large amount of deionized water is used to rinse the sidewalls, removing any residual corrosive chemicals and also removing the cutting residues in the dicing street. Insulating materials which serve as an anti-reflection layer as well as a passivation layer are formed over the surface of the cell chip. This insulating layer that covers the cleaned surface of the chip is formed by one or multiple layer of the following materials including but not limited to: silicon nitride, silicon dioxide, titanium dioxide, aluminium oxide, aluminium nitride, and magnesium fluoride. The thickness of the one or multiple insulating layers is formed to control the anti-reflection and passivation characteristics of the edge. The passivation layer formed on the surface of the cell not only reduces surface-state density but also protects the surface from damages and contamination during subsequent processing steps. In the step of cutting through the chip along the formed groove, the width of the blade used to cut through the chip is smaller than the blade used in the precise cutting for forming the sloped sidewall groove, thereby avoiding damages to the insulating layer that is formed on the sidewalls of the dicing groove in the subsequent step of cutting through the chip.

The present invention has the following advantages: firstly, a sloped sidewall groove is formed on the chip using a blade with sloping sides, such that the sidewalls of the dicing groove have a certain sloping angle, avoiding damages to the chip in the subsequent step of cutting through the chip, thereby allowing high-quality and high-reflectively passivation layer formed on the sidewalls of the groove. In addition, the width of the blade used in the subsequent step of cutting through the chip is smaller than the precise blade used in the forming of the sloped sidewall groove avoids damages to the insulating layer. Therefore, exceptionally high quality passivated edges of the solar cell chip can be obtained, resulting in the elimination of edge current leakage.

### BRIEF DESCRIPTION OF THE DRAWINGS

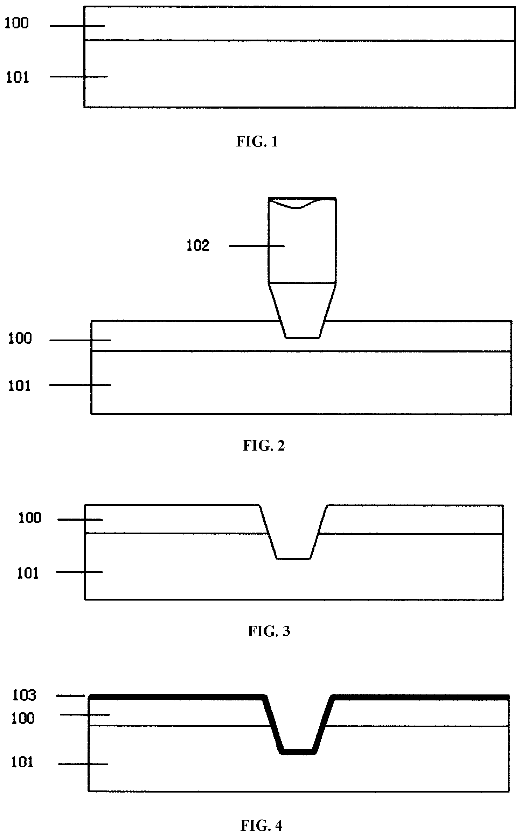

Figure 1 to Figure 6 illustrate a processing flow of a method for fabricating a concentrated solar cell chip without edge current leakage.

In the accompanying drawings: 100: epitaxial structure of solar cell; 101: germanium or gallium arsenide substrate;
102: precise sloped sidewall cutting blade; 103: insulating layer; and
104: cutting-through blade.

### DETAILED DESCRIPTION OF THE INVENTION

The present invention is described in details hereinafter in conjunction with the accompanying drawings and the embodiments.

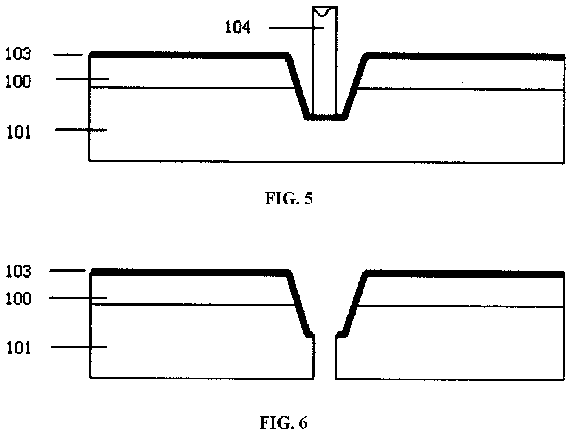

A method of fabricating a concentrated solar cell chip without edge current leakage is provided. The method includes the following processing steps:
As shown in Figure 1, surface contamination on the chip is removed by acetone or isopropyl in an ultrasonic bath, rinsing with a large amount of deionized water, removing the native oxide layer on the surface by using a mixture of citric acid and hydrogen peroxide or a mixture of sulfuric acid and hydrogen peroxide to expose the virgin surface, and blowing dry with clean nitrogen;
photoetching to form a front electrode pattern by spin coating a photoresist layer, pre-baking, exposure, post-baking, developing, cleaning, and hard-baking, .etc;
depositing front electrode metal layer by electron-beam evaporation or magnetron sputtering, .etc;
removing the photoresist by acetone in an ultrasonic bath, to form the front electrode pattern;
removing the residual photoresist on the surface by using a photoresist-stripper rinsing with a large amount of deionized water, and blowing dry with clean nitrogen;
forming an alloyed ohmic contact with the front electrode;
spin coating a photoresist on the surface, in order to protect the surface of the chip from damages in the subsequent steps such as the cutting, chemical polishing and passivation;
as shown in Figure 2, cutting a sloped sidewall groove by using a blade with having sloping sides. The slope angle is between 10°∼80', and the depth of the groove is between 10-50 microns, preferably, passing through the epitaxial structure of the solar cell. The sidewalls of the resulting dicing street also have a certain slope angle, as shown in Figure 3;
damages removal and passivation of the sidewalls of the dicing groove by using a mixture of glacial acetic acid, nitric acid, and hydrofluoric acid, to remove the damages to the sidewalls caused by the blade during cutting, followed by rinsing with a large amount of deionized water;
removing the protective photoresist layer by using a photoresist-stripping solution;
removing the cap layer on the part of the surface that is not covered by metal electrode by using citric acid or hydrogen peroxide, to eliminate absorption of light by the cap layer;
as shown in Figure 4, depositing a passivation layer. The thickness of the passivation layer is precisely controlled such that the layer has the functionality of both passivation and anti-reflection.
depositing a back metal electrode, and forming an alloyed ohmic contact;
depositing a multi-layer optical film on the front, to serve as an anti-reflection layer to reduce light reflection;
as shown in Figure 5, the chip is cut through by using a blade having a width that is slightly smaller than the width of the blade used in forming the sloped sidewall groove, to separate into individual solar cell chips. The final product is shown in Figure 6.

The present invention uses a precise sloped sidewall groove cutting method along the dicing street of the cell chip and a blade having sloping sides, so that sidewalls of the dicing groove have s sloping angle of 10-80 degrees, this sloping angle profile of the sidewall improves coverage of the deposited the passivation layer and prevents dicing damages to the passivation layer by the smaller blade in the subsequent step of cutting through the chip; the sidewalls of the groove are chemically polished; and insulating materials which serve as an anti-reflection layer are formed over the surface on the sloped sidewall groove of the cell chip, thereby passivating the surface to prevent current leakage; finally, the chip is cut through by using a blade with a smaller width.

The embodiments above are for illustrative purpose only, and should not be interpreted as limiting the scope of the present invention. Various modifications can be made by those skilled in the art without departing from the scope of the present invention, which is defined by the claims.

## Claims

1. A method for fabricating a solar cell chip without edge current leakage in a concentrated solar power system, comprising:
forming a groove along a dicing street of a cell chip by a precise sloped-sidewall cutting method using a cutting blade (102) having sloping sides, such that sidewalls of the formed groove are sloped;
performing chemical polishing on the sidewalls of the sloped sidewall groove;
forming insulating materials (103), which serves as an anti-reflection and a passivation layer, over a surface of the cell chip and over a surface on the sloped sidewalls of the groove, to prevent current leakage;
after forming the insulating materials (103), cutting through the cell chip by using a conventional blade (104) to separate the solar cell chip into individual dices, wherein the width of the conventional blade (104) is smaller than the width of the sloped-sidewall groove cutting blade (102).

2. The method according to claim 1, wherein, the shape of the sloped-sidewall cutting blade (102) has a slope angle ranging from 10° to 80°.

3. The method according to claim 1, wherein, the chemical polishing on the sidewalls of the groove is by a wet method.

4. The method according to claim 1, wherein, the chemical polishing on the sidewalls of the groove is by a dry method.

5. The method according to claim 1, wherein, the sloped sidewalls are covered with one or multiple layers of insulating materials.

6. The method of claim 5, wherein the one or multiple layers comprise at least one of the following: silicon nitride, silicon dioxide, titanium dioxide, aluminium oxide, aluminium nitride, and magnesium fluoride.

## Patentansprüche

1. Verfahren zur Herstellung eines Solarzellchips ohne Kantenleckstrom in einem konzentrierten Solarenergiesystem, umfassend:
Bilden einer Rille entlang einer Dicing-Straße eines Zellchips durch ein präzises Schneidverfahren für abgeschrägte Seitenwände unter Verwendung einer Schneidklinge (102) mit schrägen Seiten, so dass die Seitenwände der gebildeten Rille abgeschrägt sind;
Durchführen von chemischem Polieren der Seitenwände der abgeschrägten Seitenwandrille;
Bilden von Isoliermaterialien (103), die als Antireflektions- und Passivierungsschicht dienen, über einer Oberfläche des Zellchips und über einer Oberfläche der abgeschrägten Seitenwände der Rille, um Leckstrom zu verhindern;
Schneiden durch den Zellchip unter Verwendung einer konventionellen Klinge (104) nach Bildung der Isoliermaterialien (103), um den Solarzellchip in individuelle Dices zu trennen, wobei die Breite der konventionellen Klinge (104) kleiner als die Breite der Schneidklinge (102) für die Rille mit abgeschrägten Seitenwänden ist.

2. Verfahren nach Anspruch 1, wobei die Form der Schneidklinge (102) für die abgeschrägte Seitenwand einen Neigungswinkel im Bereich von 10° bis 80° aufweist.

3. Verfahren nach Anspruch 1, wobei das chemische Polieren der Seitenwände der Rille ein Nassverfahren ist.

4. Verfahren nach Anspruch 1, wobei das chemische Polieren der Seitenwände der Rille ein Trockenverfahren ist.

5. Verfahren nach Anspruch 1, wobei die abgeschrägten Seitenwände mit einer oder mehreren Schichten aus Isoliermaterialien bedeckt sind.

6. Verfahren nach Anspruch 5, wobei die eine oder mehreren Schichten mindestens eines der Folgenden umfasst bzw. umfassen: Siliciumnitrid, Siliciumdioxid, Titandioxid, Aluminiumoxid, Aluminiumnitrid und Magnesiumfluorid.

## Revendications

1. Procédé de fabrication d'une puce de cellule solaire sans fuite de courant de bord dans un système d'énergie solaire concentré, comprenant les étapes suivantes :
former un sillon le long d'un chemin de découpe d'une puce de cellule par un procédé de coupe précise de parois latérales inclinées au moyen d'une lame de coupe (102) ayant des côtés inclinés, de telle sorte que les parois latérales du sillon formé soient inclinées ;
effectuer un polissage chimique sur les parois latérales du sillon aux parois latérales inclinées ;
former des matériaux isolants (103), qui servent de couche antireflet et de passivation, sur une surface de la puce de cellule et sur une surface des parois latérales inclinées du sillon, pour empêcher la fuite de courant ;
après avoir formé les matériaux isolants (103), couper à travers la puce de cellule en utilisant une lame conventionnelle (104) pour séparer la puce de cellule solaire en puces individuelles, la largeur de la lame conventionnelle (104) étant inférieure à la largeur de la lame de coupe du sillon aux parois latérales inclinées (102).

2. Procédé selon la revendication 1, dans lequel la forme de la lame de coupe des parois latérales inclinées (102) a un angle d'inclinaison allant de 10° à 80°.

3. Procédé selon la revendication 1, dans lequel le polissage chimique sur les parois latérales du sillon se fait par un procédé humide.

4. Procédé selon la revendication 1, dans lequel le polissage chimique sur les parois latérales du sillon se fait par un procédé sec.

5. Procédé selon la revendication 1, dans lequel les parois latérales inclinées sont recouvertes d'une ou de multiples couches de matériaux isolants.

6. Procédé selon la revendication 5, dans lequel la ou les multiples couches comprennent au moins un des composés suivants : nitrure de silicium, dioxyde de silicium, dioxyde de titane, oxyde d'aluminium, nitrure d'aluminium, et fluorure de magnésium.
